# EUROPÄISCHE PATENTANMELDUNG

(11) **EP 1 986 237 A2**
(43) Veröffentlichungstag der Anmeldung: **29.10.2008**
(21) Anmeldenummer: 08007824.9
(22) Anmeldetag: 23.04.2008
(51) Int. Cl.: H01L 27/02, H01L 27/118, G06F 17/50, H01L 23/522, H01L 23/66

(54) **Verfahren zur Erzeugung eines Layouts, Verwendung eines Transistorlayouts und Halbleiterschaltung**

(30) Priorität: 26.04.2007 US 924019 P; 27.04.2007 DE 102007019940
(71) Anmelder: ATMEL Germany GmbH, 74072 Heilbronn (DE)
(72) Erfinder: Krauss, Martin, 74182 Obersulm (DE)
(74) Vertreter: Koch Müller Patentanwaltsgesellschaft mbH

(57) **Zusammenfassung**

Verfahren zur Erzeugung eines Layouts, Verwendung eines Transistorlayouts und Halbleiterschaltung
- mit einer Matching-Struktur (1), die eine Anzahl von Transistoren (M1-M4) aufweist, deren Aufbau einander gleichen,
- mit Metallisierungsebenen (MET1-MET4) mit geometrisch ausgebildeten Leiterbahnen (S1-S28), die unmittelbar oberhalb der Transistoren (M1-M4) ausgebildet sind,
- mit Vias (VIA1, VIA2, VIA3) (in Viaebenen), die zwischen zwei der Metallisierungsebenen (MET1, MET2, MET3, MET4) ausgebildet sind,
- bei der innerhalb ein und derselben Metallisierungsebene (MET1, MET2, MET3, MET4) die Geometrie der Leiterbahnen (S1-S28) oberhalb jedes Transistors (M1-M4) gleich ausgebildet ist.

## Beschreibung

Die vorliegende Erfindung betrifft ein Verfahren zur Erzeugung eines Layouts, eine Verwendung eines Transistorlayouts und eine Halbleiterschaltung.

Beim Entwurf (Layout) für die Herstellung von Halbleiterbauteilen werden heutzutage rechnergestützte Designumgebungen verwendet, die Grundbauelemente, wie Transistoren, Widerstände etc. in einer Bauelementeebene als variable Zellen (Generatoren) zur Verfügung stellen. Um möglichst viele Freiheitsgrade bei der Verdrahtung dieser Elemente zu erreichen, sind diese nur mit Anschlüssen für die unterste Metallisierungsebene ausgestattet. Hierzu sind Kontakte zwischen den Bauelementen und der untersten Metallisierungsebene vorgesehen. Diese Kontakte können als Verbindungselemente einer Kontaktebene angesehen werden. Aus der US 2005/0224982 A1 ist eine mittels Vias konfigurierbare Architektur einer Halbleiterschaltung für anwendungsspezifische Analogschaltkreise bekannt. Aus der US 2002/0040986 A1 ist eine Halbleiterschaltung mit einer Dummy-Struktur bekannt. Aus der DE 35 14 266 A1 ist ein Baustein zur Erzeugung integrierter Schaltungen bekannt. Dieser weist ein Leiterbahnfeld mit sich gitterförmig kreuzenden Leiterbahnen auf.

Weiterhin sind beim Entwurf und bei der praktischen Realisierung von Halbleiterbauteilen, wie beispielsweise der Eingangsstufe eines Verstärkers oder einem Digital-Analog-Wandler (DAC), regelmäßig so genannte Matching-Anforderungen zu erfüllen, wodurch sichergestellt werden soll, dass sich einzelne Pfade des erzeugten Halbleiterbauteils elektrisch, d.h. signaltechnisch, zueinander gleich verhalten. Derartige Matching-Anforderungen werden durch Matching-Strukturen realisiert, die auch als Paarungs-Strukturen bezeichnet werden können. Vorteilhafterweise werden die einzelnen Elemente relativ groß dimensioniert. Dabei werden derartige zusammengesetzte Halbleiterbauteile in der Praxis regelmäßig in einem Feld aus identischen (Halbleiter-)Elementen erzeugt, die auf einem Wafer um einen gemeinsamen Schwerpunkt herum verteilt angeordnet sind, um mögliche Gradienten auszugleichen, die sich durch Prozesstoleranzen entlang der Oberfläche ergeben. Bei derartigen Gradienten handelt es sich allgemein um lokale Unterschiede zwischen elektrischen Parametern, wie einer Spannung, die auf einer Vielzahl möglicher Ursachen beruhen können. Beispielhaft seien hier genannt: Inhomogenitäten von Prozessparametern (Schichtdicken, Dotierung etc.), mechanische Spannungen, Ungleiche Wärmeverteilung im Betrieb und dergleichen.

Der Erfindung liegt die Aufgabe zugrunde eine möglichst verbesserte Halbleiterschaltung anzugeben.

Die Aufgabe wird gelöst durch eine Halbleiterschaltung mit den Merkmalen des Anspruchs 1. Vorteilhafte Weiterbildungen sind in abhängigen Ansprüchen und in der Beschreibung enthalten.

Demzufolge ist eine Halbleiterschaltung mit einer Matching-Struktur vorgesehen. Die Halbleiterschaltung kann auch als Halbleiterbauteil bezeichnet werden. Die Matching-Struktur kann auch als Paarungs-Struktur bezeichnet werden. Die Matching-Struktur weist eine Anzahl von Transistoren auf, deren Aufbau einander gleichen. Der Aufbau der Transistoren weist dabei die für die Funktion des Transistors benötigten Halbleitergebiete und Isolatorgebiete auf. Vorzugsweise sind die Transistoren Feldeffekttransistoren mit Source, Drain, Body und Gate-Elektrode, beispielsweise aus dotiertem Silizium. Im Rahmen von Fertigungstoleranzen gleichen sich die Transistoren bezüglich ihres Aufbaus und ihrer elektrischen Eigenschaften. Die Transistoren sind in der atomaren Dimension meist jedoch nicht identisch.

Weiterhin weist die Halbleiterschaltung Metallisierungsebenen mit geometrisch ausgebildeten Leiterbahnen auf. Die geometrisch ausgebildeten Leiterbahnen sind dabei unmittelbar oberhalb der Transistoren ausgebildet. Somit sind zwischen den geometrisch ausgebildeten Leiterbahnen und den Transistoren keine weiteren Leiter in einer Ebene dazwischen angeordnet. Die Leiterbahnen sind vorzugsweise metallische Leiter. Alternativ kann dotiertes Halbleitermaterial als Leiterbahn verwendet werden.

Weiterhin weist die Halbleiterschaltung Vias in Viaebenen auf. Die Vias sind zwischen jeweils zwei der Metallisierungsebenen ausgebildet. Ein Via ist dabei ein mit einem leitenden Material gefüllte Öffnung in einer Isolatorschicht der Viaebene. Je nach Position des Vias kann mit dem Via vorteilhafterweise ein Stromfluss senkrecht zur Chipoberfläche ermöglicht werden. Hierzu grenzt das Via vorzugsweise an eine erste Leiterbahn in der oberhalb des Vias angrenzenden Metallisierungsebene und an eine zweite Leiterbahn in der unterhalb des Vias angrenzenden Metallisierungsebene an.

Innerhalb ein und derselben Metallisierungsebene ist die Geometrie der Leiterbahnen oberhalb jedes Transistors der Matching-Struktur gleich ausgebildet. Hingegen kann sich die Geometrie der Leiterbahnen oberhalb ein und desselben Transistors von Metallisierungsebene zu Metallisierungsebene unterscheiden. Vorzugsweise ist die Geometrie in zumindest vier Metallisierungsebenen - die unmittelbar oberhalb der Transistoren der Matching-Struktur ausgebildet sind - besonders bevorzugt in allen Metallisierungsebenen gleich ausgebildet. Die Gleichheit kann dabei beispielsweise mittels Maskierungen im Herstellungsprozess im Rahmen gegebener Fertigungstoleranzen erzeugt werden.

Weiterhin liegt der Erfindung die Aufgabe zu Grunde ein möglichst verbessertes Verfahren zur Erzeugung eines Layouts anzugeben.

Diese Aufgabe wird gelöst durch das Verfahren mit den Merkmalen des Anspruchs 9. Vorteilhafte Weiterbildungen sind in abhängigen Ansprüchen und in der Beschreibung enthalten.

Demzufolge ist ein Verfahren zur Erzeugung eines Layouts einer Halbleiterschaltung vorgesehen. Hierzu ist vorzugsweise eine Anzahl von Hierarchiestufen vorgesehen. Eine Reihenfolge der Verfahrensschritte zur Erzeugung des Layouts können dabei von einer späteren Produktionsreihenfolge abweichen. Die Halbleiterschaltung weist dabei eine Matching-Struktur mit Transistoren auf. Dabei wird ein gleicher Aufbau der Transistoren der Matching-Struktur erzeugt.

Als Bestandteil des Layouts werden Leiterbahnen als Layoutelemente in Metallisierungsebenen unmittelbar oberhalb der Transistoren geometrisch definiert und in einer Position angeordnet. Hierzu werden entsprechende Geometrien gebildet, die in einem späteren Herstellungsprozess beispielsweise auf Maskierungen übertragbar sind. Beispielsweise ist jeder Metallisierungsebene eine Layoutschicht für diese Metallisierungsebene zugeordnet.

Als Bestandteil des Layouts werden weiterhin Vias in Viaebenen zwischen zwei Metallisierungsebenen angeordnet. In dem Layout wird dabei die Position des Vias definiert.

Innerhalb ein und derselben Metallisierungsebene wird die im Layout definierte Geometrie der Leiterbahnen oberhalb jedes Transistors gleich ausgebildet.

Weiterhin liegt der Erfindung die Aufgabe zu Grunde eine Verwendung von Geometrien von Leiterbahnen anzugeben.

Diese Aufgabe wird gelöst durch die Verwendung mit den Merkmalen des Anspruchs 13. Vorteilhafte Weiterbildungen sind in abhängigen Ansprüchen und in der Beschreibung enthalten.

Demzufolge ist eine Verwendung eine Verwendung eines Transistorlayouts einer Matching-Struktur in einem Layout-Generierungsverfahren vorgesehen. Das Transistorlayout weist dabei nicht nur die Kontaktierung eines betroffenen Transistors, sondern auch über dem Transistor ausgebildete Leiterbahnen auf. Das Transistorlayout weist dabei unveränderliche Geometrien von Leiterbahnen in mehreren unmittelbar oberhalb des Transistors ausgebildeten Metallisierungsebenen auf. Die Geometrien der Leiterbahnen sind zum Aufbau des Transistors positioniert. Vorzugsweise überlappen sich die Geometrien der Leiterbahnen bei einem benachbarten Aneinanderanordnen der Transistorlayouts teilweise.

Ein weiterer Aspekt der Erfindung ist eine Verwendung von Geometrien von Leiterbahnen zur Erzeugung von gleichen parasitären Kapazitäten. Die Leiterbahnen sind in verschiedenen Metallisierungsebenen unmittelbar oberhalb von Transistoren einer Matching-Struktur einer Halbleiterschaltung ausgebildet. Die parasitären Kapazitäten gleichen einander für jeden Transistor der Matching-Struktur, indem innerhalb ein und derselben Metallisierungsebene die Geometrie der Leiterbahnen oberhalb jedes Transistors gleich ausgebildet ist.

Die im Folgenden beschriebenen Weiterbildungen beziehen sich sowohl auf die Halbleiterschaltung, als auch auf die Verwendung von Geoemtrien von Leiterbahnen als auch auf das Verfahren zur Erzeugung eines Layouts einer Halbleiterschaltung.

Gemäß einer vorteilhaften Weiterbildung sind die Transistoren der Matching-Struktur im Layout und auf dem Chip zueinander benachbart angeordnet. Werden die Transistoren beispielsweise in einer Matrix mit Zeilen und Spalten angeordnet, hat jeder beispielsweise als Rechteck oder Quadrat ausgebildete Einzeltransistor an seinen Seiten maximal vier und an seinen Ecken diagonal versetzt maximal vier weitere Nachbartransistoren. Ist der Transistor als Sechseck ausgebildet, weist dieser entsprechend maximal sechs benachbarte Transistoren auf.

Vorzugsweise grenzt innerhalb ein und derselben Metallisierungsebene zumindest eine Leiterbahn der Geometrie oberhalb eines Transistors (der Transistoren der Matching-Struktur) an zumindest eine Leiterbahn eines benachbarten Transistors (der Transistoren der Matching-Struktur) zur Ausbildung einer leitenden Verbindung. Im Layout wird die leitende Verbindung durch eine Mindestüberlappung der Geometrien der Leiterbahnen benachbarter Transistoren erzielt.

Gemäß einer besonders bevorzugten Weiterbildung ist zumindest innerhalb der untersten Viaebene die Position der Vias bezüglich des Aufbaus jedes Transistors gleich. Vorzugsweise sind ebenfalls die Kontakte in einer Kontaktebene zwischen der untersten Metallisierungsebene und den Transistoren gleich ausgebildet.

In einer bevorzugten Ausgestaltungsvariante ist vorgesehen, dass in der dritten Viaebene oder in einer Viaebene oberhalb der dritten Viaebene die Position der Vias bezüglich des Aufbaus jedes Transistors - insbesondere zur Verschaltung der Transistoren untereinander - unterschiedlich ist. Vorteilhafterweise werden nach der Positionierung der Transistoren der Matching-Struktur zusammen mit den Geometrien der Leiterbahnen der Metallisierungsebenen Verbindungen der Transistoren der Matching-Struktur durch die Positionierung von Vias beispielsweise in der dritten Viaebene bevorzugt jedoch in der obersten Viaebene ausgebildet. Durch diese Verbindungen können die Transistoren miteinander verschaltet werden.

Entsprechend einer bevorzugten Weiterbildung weist die Geometrie der Leiterbahnen innerhalb zumindest einer Metallisierungsebene eine Mehrzahl zueinander paralleler Streifen auf. Vorzugsweise sind die parallelen Streifen zueinander in einem äquidistanten Abstand angeordnet. Vorzugsweise erstrecken sich die Streifen über den überwiegenden Teil der Abmessungen des Transistors. Bevorzugt dienen die Streifen zur elektrischen Verbindung oder sind alternativ mit einem Bezugspotential - beispielsweise Masse - verbunden. Ebenfalls ist eine Schirmungsfunktion durch die Streifen realisierbar.

In einer bevorzugten Weiterbildung weist die Matching-Struktur Dummy-Transistoren auf. Die Dummy-Transistoren weisen einen Aufbau auf, der dem der Transistoren gleicht. Vorteilhafterweise werden die Dummy-Transistoren im Layout mit gleicher Geometrie wie die aktiven Transistoren angeordnet jedoch nicht in der Funktion als Transistor verschaltet, sondern beispielsweise mit einem Bezugspotential - wie Masse, einer Versorgungsspannung oder dergleichen - verbunden. Vorzugsweise sind die Dummy-Transistoren am Rand der Matching-Struktur angeordnet. Vorzugsweise sind die Transistoren von Dummy-Transistoren - beispielsweise in Form eines Rechtecks oder Quadrats - vollständig umgeben. Innerhalb ein und derselben Metallisierungsebene ist die Geometrie der Leiterbahnen oberhalb jedes Transistors und jedes Dummy-Transistors vorteilhafterweise gleich ausgebildet.

In einer Weiterbildungsvariante ist vorgesehen, dass ausschließlich außerhalb der Matching-Struktur zwischen Leiterbahnen der Metallisierungsebenen Füllstrukturen automatisch angeordnet sind. Derartige Füllstrukturen sind vorteilhafterweise aus demselben Material und in denselben Prozessschritten herstellte Strukturen, wie die der Leiterbahnen. Beispielsweise sind dies durch ein Rechenprogramm automatisch positionierte Metallstreifen, die nicht angeschlossen sind und daher floaten. Die Füllstrukturen werden dabei benötigt, wenn zwischen der Ausbildung der Metallisierungsebenen im Herstellungsprozess ein Planarisierungsschritt vorgesehen ist, der ein Verhältnis von Leiterbahnfläche zu freier Fläche, die nicht von Leiterbahnen bedeckt ist, benötigt.

Gemäß einer vorteilhaften Ausgestaltung ist daher vorgesehen, dass zumindest innerhalb ein und derselben Metallisierungsebene außerhalb der Matching-Struktur ein erstes Überdeckungsverhältnis von Leiterbahnen und Füllstrukturen zu freibleibender Fläche und ein zweites Überdeckungsverhältnis der Geometrie der Leiterbahnen zu freibleibender Fläche der Matching-Struktur innerhalb ein und desselben Wertebereichs liegen. Der Wertebereich ist vorteilhafterweise zwischen 30% und 70% Überdeckungsverhältnis.

In einer vorteilhaften Weiterbildung wird jeder Transistor der Matching-Struktur als Modul mit unveränderlichen Geometrien der Leiterbahnen in den Metallisierungsebenen positioniert. Vorzugsweise wird jeder Transistor benachbart zu zumindest einem weiteren Transistor der Matching-Struktur positioniert, wobei die Geometrien sich vorteilhafterweise teilweise überlappen. Unter einem Modul ist dabei der Transistor mit seinem Aufbau gemeinsam mit der Geometrie der Leiterbahnen in der jeweiligen Metallisierungsebene zu verstehen, so dass die Leiterbahnen der Metallisierungsebenen nicht verändert werden können. Vorzugsweise können ausschließlich die Vias in ihrer Position verändert werden. Besonders bevorzugt können nur die Vias der obersten Viaebene in ihrer Position - vorzugsweise in einer anderen Hierarchieebene der Layoutgenerierung als die Module - gesetzt werden.

Vorzugsweise ist als Geometrie der Leiterbahn eine Metallstruktur des mit einer Anzahl von Anschlussleitungen im Wesentlichen vollständig angelegt. Zum Schaffen der auch als Halbleiterbauteil bezeichneten Halbleiterschaltung sind optionale Verbindungen zwischen den Anschlussleitungen der Metallstruktur anzulegen. Dies erfolgt insbesondere in Abhängigkeit von einer Position des Transistors als Halbleiterelement in einem Feld auf dem Chip.

Gemäß einer bevorzugten Weiterbildung ist vorgesehen, dass nach einer Positionierung der Transistoren der Matching-Struktur und ggf. weiterer Layoutgenerierungsschritte zwischen Leiterbahnen der Metallisierungsebenen Füllstrukturen automatisch angeordnet werden, wobei im Bereich der Matching-Struktur die automatische Anordnung von Füllstrukturen deaktiviert wird.

Vorzugsweise ist die Matching-Struktur in einem Feld auf dem Chip angeordnet. Vorteilhafterweise werden die Transistoren mittels einer Anordnung von Halbleiter- und Isolationsschichten erzeugt. Vorteilhafterweise werden anschließend die Halbleiterschichten über die Leiterbahnen, insbesondere über eine Metallstruktur elektrisch kontaktiert und zu der Halbleiterschaltung verbunden.

Vorteilhafterweise weisen die Leiterbahnen eine Anzahl von Anschlussleitungen auf. Vorteilhafterweise werden die Anschlussleitungen der Transistoren mittels Vias zwischen Anschlussleitungen der entsprechenden Leiterbahn verbunden. Vorzugsweise überdecken die Anschlussleitungen oder die Leiterbahnen dabei einen Anteil- insbesondere 30-70% - der Fläche des Transistors.

Vorzugsweise sind Anschlussleitungen der Leiterbahnen innerhalb einer Metallisierungsebene derart positioniert, dass sich diese Anschlussleitungen über mehrere aneinander angeordnete Transistoren erstrecken. Beispielsweise erstreckt sich eine Anschlussleitung über eine gesamte Zeile oder Spalte von Transistoren. Weitere Leiterbahnen, die insbesondere nicht mit Anschlusseinrichtungen für den Transistor zu verbinden sind, können vorteilhafterweise mit einem Abschirm- und/oder Referenzpotential verbunden werden.

Vorzugsweise werden die Transistoren der Matching-Struktur in einer Matrix mit Zeilen und Spalten zeilenweise und/oder spaltenweise angeordnet. Vorteilhafterweise werden die Transistoren zu der Matching-Struktur verbunden. Vorteilhafterweise werden zum Erzeugen der Transistoren aus mehreren parallelgeschalteten Einzeltransistoren die Transistoren einer Zeile und/oder Spalte in ihrer Reihenfolge gegenüber den Transistoren einer anderen Zeile bzw. Spalte vertauscht angeordnet, insbesondere permutiert.

Ein weiterer Aspekt der Erfindung ist ein Halbzeug zum Herstellen wenigstens einer Halbleiterschaltung. Ein weiterer Aspekt der Erfindung ist ein computerimplementiertes Verfahren zur Erzeugung eines Layouts gemäß einer der vorhergehenden Ausführungen. Ein weiterer Aspekt ist ein Datenträger mit einem Softwareprogramm zur Erzeugung eines Layouts gemäß einer der vorhergehenden Ausführungen. Ein weiterer Aspekt der Erfindung ist ein Datenträger mit Layoutdaten einer zuvor angegebenen Matching-Struktur.

Im Kontext einer Ausgestaltung der vorliegenden Erfindung ist ein zu erzeugender Transitor als Halbleiterbauteil in einem Feld auf dem Chip mit einer Anzahl von Zellen ausgebildet, wobei jede Zelle einen Einzeltransistor und zusätzlich die jeweils darüber liegenden Metallisierungs- und Via-Ebenen (Verbindungsebenen) enthält. Die vorstehend genannten Metallisierungsebenen, die vorteilhafterweise jeweils Leiterbahnen, - beispielsweise Metallstrukturen - mit einer Anzahl von Anschlussleitungen darstellen, sind vorzugsweise so strukturiert, dass sie für jede Zelle die notwendige insbesondere metallische Flächenüberdeckung aufweisen und vorteilhaferweise zum Anschluss des Einzeltransistors bzw. für eine Zuführung der entsprechenden Anschlussnetze (Eingänge, Ausgänge oder dergleichen) oder zur Schirmung der einzelnen Elemente dienen.

Ein aus derartigen Zellen bestehendes Feld stellt somit vorteilhafterweise - nach seiner praktischen Realisierung - ein Halbzeug zum Herstellen wenigstens eines Halbleiterbauteils dar, das - abgesehen von den vorstehend genannten Anschlüssen, die jeweils von einer Position des Einzelelements in dem Feld abhängen, - überwiegendverdrahtet ist. Vorzugsweise werden die fehlenden Verbindungen zum Anschluss der betreffenden Netze anschließend an optional dafür vorgesehenen Anschlusspunkten, vorzugsweise durch Vias (engl.: vertical interconnect access) realisiert, insbesondere auf einer neuen, oberen Hierarchieebene des Layouts. Vorzugsweise sind die Metallstrukturen für Elemente, insbesondere Transistoren einer Gruppe, die zum Schaffen einer Matching-Struktur zusammengeschaltet werden, gleich ausgebildet, um vorgegebene Matching-Anforderungen zu erfüllen.

Vorteilhafterweise enthält das (Layout-)Verfahren der zur Bildung der Matching-Struktur verwendete Transistor als Halbleiterelement bereits den darüber liegenden Verdrahtungsanteil in mehreren - beispielsweise allen - Metallebenen (METx; x = 1, 2, ...), unter Berücksichtigung der geforderten elektrischen und prozesstechnischen Randbedingungen. Dies wird vorzugsweise durch eine zusätzliche Hierarchieebene bzw. Zelle erreicht, die erfindungsgemäß sowohl das ursprünglich von der Designumgebung zur Verfügung gestellte Grundelement (den Transistor) als auch die darüber liegenden Leiterbahnen, beispielsweise als Metallstukturen enthält.

Das erfindungsgemäße Verfahren zeichnet sich bezüglich einer Hierarchie in der Layoutgenerierung dadurch aus, dass in der sonst üblichen Verdrahtungsebene, auf der die Einzelelemente aufgerufen und miteinander zu der Matching-Struktur verbunden werden, keine Leiterbahnen mehr zu entwerfen sind. Lediglich ein kleiner Rest von Verbindungen, die durch die Position der Elemente im Feld festgelegt sind, werden vorteilhafterweise an entsprechend vorbereiteten Stellen des jeweiligen Elements durch Setzen von Vias ausgeführt.
Vorteilhafterweise wird eine zusätzliche (Layout-)Hierarchieebene vorgesehen, auf der vorab angelegte geometrische Leiterbahnen - beispielsweise als Metallstrukturen -, die zumindest diesbezüglich eine topographische Gleichheit aller Elemente des Feldes sicherstellen, und anschließend in Abhängigkeit von der Position des Einzelelements im Feld zu Zwecken der Verdrahtung verbunden werden, lässt sich nicht nur beim Entwerfen von Matching-Strukturen, sondern entsprechend auch praktisch bei deren Herstellung oder Fertigung in einer Halbleiterschaltung vorteilhafterweise einsetzen, indem vorzugsweise die Herstellung unter Verwendung eines erfindungsgemäß erzeugten Layouts erfolgt.

Eine bevorzugte Verwendung des Verfahrens liegt im Bereich des Layouts, beispielsweise als entsprechende Funktion bei der softwarebasierten und rechnergestützten Planung / Entwurf von Halbleiterschaltungen als Halbleiterbauteilen, die von herkömmlicher Weise hierfür eingesetzten sog. EDA-Werkzeugen nicht bereit gestellt wird.

Durch die zusätzliche Hierarchieebene, die gemäß bestimmter Ausgestaltungen der Erfindung insbesondere zur Bildung einer Matching-Struktur nötig ist, geht der direkte Bezug von Layout und "Schematic" verloren (wichtig im Kontext von SDL - schematic driven layout). Das Verfahren ist damimt ein Teil eines Herstellungsverfahrens für Halbleiterschaltungen.Die entsprechende Fertigung des Silizium-Wafers läuft prinzipiell in herkömmlicher Weise ab - vorliegend allerdings unter Verwendung der mittels erzeugter Layoutdaten hergestellten Masken.Es besteht vorteilhafterweise die Möglichkeit, Wafer mit Ausnahme der obersten Metallisierungs- und Via-Ebene, die zum Schaffen von (optionalen und insbesondere positionsabhängigen Verbindungen zwischen Anschlussleitungen eines Halbleiterelements dient, voll durchzuprozessieren und anschließend (unfertig) nach Art eines Halbzeugs stehenzulassen. Halbleiterbauteile bzw. -elemente auf diesem Wafer können dann über die noch verbleibenden (Verbindungs-) Prozessschritte in ihrer späteren elektrischen Funktion bzw. ihrer elektrischen Parameter beeinflusst werden.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Einige mögliche Kombinationen sind in der Beschreibung der Ausführungsbeispiele der Figuren erläutert. Diese dort dargestellten Möglichkeiten von Kombinationen der Weiterbildungsvarianten sind jedoch nicht abschließend.

Im Folgenden wird die Erfindung durch Ausführungsbeispiele anhand zeichnerischer Darstellungen näher erläutert.

Dabei zeigen
- Fig. 1: ein Schaltungsdiagramm der Eingangsstufe eines Verstärkers, die eine Halbleiterschaltung als Halbleiterbauteil im Sinne der vorliegenden Erfindung darstellt, mit eingezeichneten parasitären Kapazitäten;
- Fig. 2: ein topologisches Schema der Leitungsführung in einer Zelle, die einen Transistor als einzelnes Halbleiterelement für das Halbleiterbauteil in Fig. 1 enthält;
- Fig. 3: ein topologisches Schema der Leitungsführung durch ein aus Zellen gemäß Fig. 2 gebildetes Feld von Transistoren als Halbleiterelemente;
- Fig. 4: einen ersten Horizontalschnitt eines Layouts für einen Transistor als Halbleiterelement;
- Fig. 5: einen zweiten Horizontalschnitt eines Layouts für einen Transistor als Halbleiterelement;
- Fig. 6: einen dritten Horizontalschnitt eines Layouts für einen Transistor als Halbleiterelement;
- Fig. 7: einen vierten Horizontalschnitt eines Layouts für einen Transistor als Halbleiterelement;
- Fig. 8: einen ersten Horizontalschnitt durch ein Layout für eine Anordnung von Transistoren als Halbleiterelemente gemäß den Figuren 4 bis 7;
- Fig. 9: einen weiteren Horizontalschnitt durch ein Layout für eine Anordnung von Transistoren als Halbleiterelementen gemäß Fig. 8;
- Fig. 10: einen weiteren Horizontalschnitt durch ein Layout für eine Anordnung von Transistoren als Halbleiterelementen gemäß Fig. 8; und
- Fig. 11: einen weiteren Horizontalschnitt durch ein Layout für eine Anordnung von Transistoren als Halbleiterelementen gemäß Fig. 8.

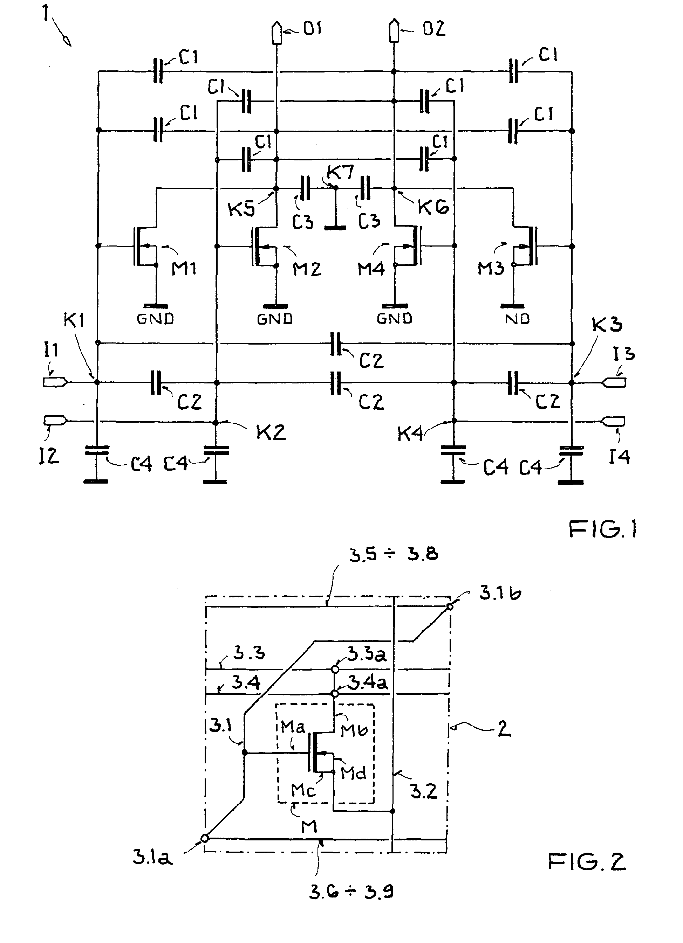

Fig. 1 zeigt die Eingangsstufe 1 eines weiter nicht dargestellten Verstärkers als Halbleiterschaltung. Die Eingangsstufe 1 weist Halbleiterelemente in Form von ersten bis vierten Feldeffekt-Transistoren (MOSFETs) M1-M4 sowie Eingänge I1-I4 und Ausgänge 01-02 auf und dient vorliegend lediglich als mögliches Beispiel für eine Halbleiterschaltung, die nachfolgend auch als monolithisch integriertesHalbleiterbauteil bezeichnet wird. Die Halbleiterschaltung weist eine Matching-Struktur auf, die eine Anzahl gleicher Transistoren M1-M4 als Halbleiterelemente aufweist. Vorliegend sind die Transistoren M1-M4 identisch mit einer Kanalbreite W = 30 µ, einer Kanallänge L = 20 µ und m = 4 (d.h. es sind vier Transistoren parallel geschaltet) ausgebildet. Source- und Bulk-Anschlüsse der Transistoren M1-M4 liegen auf Massepotential GND. Gate-Anschlüsse der Transistoren M1-M4 sind über Knoten K1-K4 jeweils mit einem entsprechenden Eingang I1-I4 verbunden. Drain-Anschlüsse der Transistoren M1 und M2 sind zu einem gemeinsamen Knoten K5 geführt, während Drain-Anschlüsse der Transistoren M3 und M4 zu einem gemeinsamen Knoten K6 geführt sind. Ein zwischen den Knoten K5 und K6 liegender Knoten K7 ist mit Massepotential GND verbunden. Der Knoten K5 ist mit einem ersten Ausgang 01 und der Knoten K6 mit einem zweiten Ausgang 02 der Eingangsstufe 1 verbunden.

Da die Eingangsstufe 1 - wie erwähnt - als Halbleiterbauteil ausgeführt ist, ergeben sich bei der praktischen Realisierung eine Reihe von parasitären Kapazitäten C1-C4 zwischen Teilstrukturen der Eingangsstufe 1, insbesondere zwischen den vorstehend erwähnten Knoten K1-K7. Exemplarisch sei hier auf die parasitären Kapazitäten C4 hingewiesen, die jeweils an den Knoten K1-K4 vorhanden sind. Parasitäre Kapazitäten C2 existieren zwischen den Knotenpaaren K1/K2, K2/K4, K3/K4 und K1/K3. Parasitäre Kapazitäten C3 existieren zwischen dem Knoten K7 und dem Knoten K5 bzw. K6. Weitere parasitäre Kapazitäten C1 finden sich jeweils zwischen dem Gate-Anschluss der Transistoren M1-M4 und dem Ausgang 01 bzw. 02.

Wenn ein Halbleiterbauteil, wie die Eingangsstufe 1 gemäß Fig. 1, auf den Halbleiterelementen/Transistoren M1-M4 aufbauend als Layout oder physikalisch realisiert bzw. verdrahtet werden soll, ist darauf zu achten, dass die einzelnen elektrischen (Signal-)Pfade des fertigen Halbleiterbauteils in Bezug auf eine bestimmte elektrische Kenngröße im Wesentlichen miteinander übereinstimmen (paaren/matchen). Dabei kann gefordert sein, dass die Übereinstimmung in Bezug auf die genannte Kenngröße < 0,1% ist. Mit anderen Worten: Die Halbleiterelemente M1-M4 und die Ein- und Ausgänge I1-I4, O1-O2 sollen derart miteinander verbunden werden, dass sich eine größtmögliche Übereinstimmung der einzelnen (Signal-) Pfade ergibt. Dazu ist aus dynamischen Gründen die Übereinstimmung (Symmetrie) der zusätzlich in Fig. 1 eingezeichneten und vorstehend erläuterten möglichen parasitären Kapazitäten C1-C4 erforderlich. Dies gilt im Besonderen für die Kapazität C1. Darüber hinaus ist im Falle des gezeigten Ausführungsbeispiels der Fig. 1 erforderlich, dass die parasitären Kapazitäten C1 und C2 möglichst klein sind.

In diesem Zusammenhang sieht das dargestellte Ausführungsbeispiel vor, das zu realisierende Halbleiterbauteil, vorliegend also die Eingangsstufe 1 gemäß Fig. 1, als eine Anordnung gleicher, d.h. vom Typ her identischer Zellen aufzubauen, die jeweils ein einzelnes Halbleiterelement (oder Einzelelement) und alle zur Verdrahtung erforderlichen geometrisch ausgebildeten Leiterbahnen in Metallisierungsebenen enthält. Vorzugsweise enthält es weiterhin Vias zumindest einer Via-Ebene. Innerhalb ein und derselben Metallisierungsebene ist die Geometrie der Leiterbahnen oberhalb jedes Transistors M1-M4 gleich ausgebildet. Für das vorliegende Ausführungsbeispiel ist die topologische Strukturierung der Metallisierungsebenen und Via-Ebenen in Fig. 2 dargestellt.

Fig. 2 zeigt ein topologisches Schema der Leitungsführung in einer Zelle 2, die ein einzelnes Halbleiterelement M - hier einen Feldeffekttransistor - enthält. Die strichpunktierte Umrandung in Fig. 2 stellt die Begrenzung der Zelle 2 dar, die das einzelne Halbleiterelement M in Form eines Transistors und die darüberliegenden Leitungsebenen enthält, welche dementsprechend Leiterbahnen in mehreren Metallisierungsebenen mit einer Anzahl von Anschlussleitungen (durchgezogene Linien in Fig. 2) darstellen. Die offenen Kreise in Fig. 2 stellen optionale Anschlüsse dar. Bei diesen handelt es sich um Stellen der Topologie, an den optional das Schaffen von Verbindungen zwischen den Metallisierungsebenen bzw. Anschlussleitungen über entsprechende Vias vorgesehen ist.

Das topologische Schema gemäß Fig. 2 wird nachfolgend genauer erläutert:

Das Halbleiterelement M entspricht den Transistoren M1-M4 in Fig. 1. Es weist einen Gate-Anschluss Ma, einen Drain-Anschluss Mb und miteinander verbundene Source- und Bulk-Anschlüsse Mc, Md auf. Die nachfolgend beschriebenen Anschlussleitungen bzw. Verbindungen wurden in Fig. 2 allesamt auf die (strichpunktiert umrandete) Fläche der Zelle 2 projiziert. Die Zelle 2 mit dem Transistor M und den Verbindungen 3.1 bis 3.9 ist vorzugsweise als fertiges Modul in einer Programmbibliothek zur Generierung eines Layouts vorbereitet.

Der Gate-Anschluss Ma des Transistors M ist mit einer ersten Anschlussleitung 3.1 verbunden, die sich im Wesentlichen diagonal über die Zelle 2 erstreckt. Die erste Anschlussleitung 3.1 weist an ihren Enden optionale Anschlüsse 3.1 a, 3.1 b auf, d.h. sie ist an diesen Stellen mit darüber- oder darunter liegenden Anschlussleitungen über Vias verbindbar. Des Weiteren umfasst die Zelle 2 eine sich in der gewählten Darstellung vertikal erstreckende zweite Anschlussleitung 3.2, die mit den Source- und Bulk-Anschlüssen Mc, Md des Transistors M verbunden ist. Die zweite Anschlussleitung 3.2 weist an ihren Enden, d.h. an der Zellgrenze keine optionalen Anschlüsse auf. Dies bedeutet vorliegend, dass sich die zweite Anschlussleitung 3.2 über die Zellgrenze hinweg in eine angrenzende, gleiche Zelle (nicht gezeigt) fortsetzt, ohne dass hierzu das Schaffen einer gesonderten Verbindung erforderlich wäre.

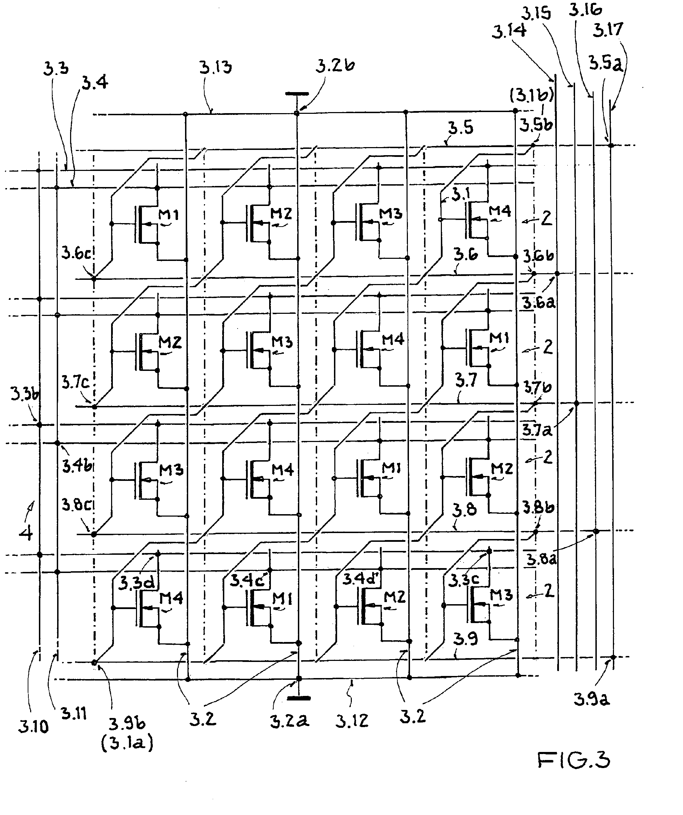

Gleiches gilt für die sich horizontal erstreckenden dritten und vierten Anschlussleitungen 3.3, 3.4 sowie für die diagonale Anschlussleitung 3.1. Erstere können zusätzlich über jeweils optionale Anschlüsse 3.3a bzw. 3.4a mit dem Drain-Anschluss Mb des Transistors M verbunden werden, wie oben für die erste Anschlussleitung 3.1 erläutert. Auf der oberen und unteren Zellgrenze (strichpunktierte Linie; in Fig. 2 aus Gründen der Übersichtlichkeit leicht nach oben bzw. unten verschoben) weist die Zelle 2 weitere horizontal verlaufende Anschlussleitungen (Gate-Anschlussleitungen) 3.5-3.9 (vgl. Fig. 3), auf die weiter unten noch genauer eingegangen wird. Auch diese Anschlussleitungen erstrecken sich über die Zellgrenze hinweg in eine angrenzende, gleiche Zelle, ohne dass hierzu das Schaffen einer gesonderten Verbindung erforderlich wäre.

Wie bereits erwähnt, sind im Layout der Zelle 2 oder einem entsprechend hergestellten Halbzeug für Halbleiterbauteile bestimmte Verbindungen optional für einen Anschluss vorbereitet, jedoch zunächst nicht kontaktiert. Die fehlenden Verbindungen sind von einer Position des anzuschließenden Einzelelements, hier also des Transistors M, in einem aus strukturell identischen, d.h. gleichen Zellen 2 gebildeten Feld abhängig und werden auf einer höheren (Layout-)Hierarchieebene durch Vias ausgeführt.

Fig. 3 zeigt ein topologisches Schema der Leitungsführung durch ein aus Zellen gemäß Fig. 2 gebildetes Feld 4 von Transistoren M1-M4 als Halbleiterelemente, wobei jeweils vier Transistoren (je ein Transistor pro Zelle) parallelgeschaltet sind. Dargestellt ist eine matrixartige Anordnung von strukturell grundsätzlich identischen Zellen 2 (vgl. Fig. 2), von denen aus Gründen der Übersichtlichkeit in Fig. 3 nur eine wenige explizit bezeichnet sind. Die Zellen 2 sind in Fig. 3 wiederum mit strichpunktierten Umrandungen versehen, wobei hier jedoch aufgrund des Vorsehens der zusätzlichen, horizontal verlaufenden (Gate-)Anschlussleitungen 3.5-3.9 genau zwischen den Zellen 2 die ebenfalls horizontal verlaufenden Umrandungslinien der Zellen 2 nicht erkennbar sind. Die Anschlussleitungen 3.5-3.9 werden topologisch von jeweils zwei Layout-Elementen (Zellen) repräsentiert, d.h. es findet beim vertikalen Anreihen der Zellen eine entsprechende Überdeckung / Überlappung statt.

In Fig. 3 sind jeweils vier Zellen 2 bzw. die entsprechenden Halbleiterelemente (Einzelelemente) gemäß der Darstellung in Fig. 1 zu einer Verstärker-Eingangsstufe zusammengeschaltet, wozu jeweils an bestimmten, anhand der Darstellung in Fig. 2 identifizierbaren Stellen der Topologie die bereits angesprochenen optionalen (Via-)Verbindungen realisiert wurden. Diese sind in Fig. 3 ebenfalls mit schwarzen Punkten markiert. Die Bezugszeichen in Fig. 3 entsprechen ansonsten denjenigen in Fig. 1 und Fig. 2.

Wie Fig. 3 insbesondere zu entnehmen ist, erstrecken sich die zweiten, vertikalen Anschlussleitungen 3.2 durch bzw. über alle Zellen 2 einer Spalte des Feldes 4. Des Weiteren erstrecken sich die horizontalen, dritten und vierten Anschlussleitungen 3.3, 3.4 jeder Zelle 2 über alle Zellen 2 einer Zeile des Feldes 4. Seitlich des Feldes 4 sind Anschlusseinrichtungen in Form weiterer Anschlussleitungen 3.10-3.17 vorgesehen, auf die nachfolgend genauer eingegangen wird: Anschlussleitung 3.10 verbindet die dritten Anschlussleitungen 3.3 über entsprechende Verbindungen (Vias) 3.3b, von denen aus Gründen der Übersichtlichkeit nur eine explizit bezeichnet ist, mit dem Ausgang 02. Anschlussleitung 3.11 verbindet die vierten Anschlussleitungen 3.4 über entsprechende Verbindungen (Vias) 3.4b, von denen aus Gründen der Übersichtlichkeit nur eine explizit bezeichnet ist, mit dem Ausgang 01. Anschlussleitung 3.12 verbindet die zweiten Anschlussleitungen über entsprechende Verbindungen (Vias) 3.2a, von denen aus Gründen der Übersichtlichkeit wiederum nur eine explizit bezeichnet ist, mit dem Abschirm- und Referenzpotential GND (Masse). Ebenso verbindet Anschlussleitung 3.13 über entsprechende Verbindungen (Vias) 3.2b die zweiten Anschlussleitungen 3.2 mit dem Abschirm- und Referenzpotential GND. Anschlussleitungen 3.14-3.17 sorgen über entsprechende Verbindungen (Vias) mit den Anschlussleitungen 3.5-3.9, auf die weiter unten noch genauer eingegangen wird, für eine signaltechnische Wirkverbindung mit den Eingängen I1-I4.

Vorliegend bilden die Halbleiterelemente (Transistoren M1-M4) jeder Zeile der Matrix bzw. des Feldes 4 jeweils eine Eingangsstufe 1 gemäß Fig. 1. Exemplarisch wird im Folgenden in erster Linie auf die unterste Zeile des Feldes 4 Bezug genommen.

Die gemeinsamen Source-/Bulk-Anschlüsse der Transistoren M1-M4 sind über die zweiten Anschlussleitungen 3.2 und die Verbindungen 3.2a, 3.2b sowie über die Anschlussleitungen 3.12, 3.13 mit Massepotential GND verbunden. Die Drain-Anschlüsse der Transistoren M1, M2 der beiden mittleren Zellen 2 sind über Verbindungen (Vias) 3.4c bzw. 3.4d mit der zugehörigen vierten Anschlussleitung 3.4 und somit über die Verbindung 3.4b über die Anschlussleitung 3.11 mit dem Ausgang 01 verbunden. Des Weiteren sind die Drain-Anschlüsse der Transistoren M3, M4 der äußeren Zellen 2 über Verbindungen (Vias) 3.3c bzw. 3.3d mit der zugehörigen dritten Anschlussleitung 3.3 verbunden, sodass sich über die weitere Verbindung 3.3b und die Anschlussleitung 3.10 eine Verbindung zu dem Ausgang 02 ergibt. Für die Verbindung der Gate-Anschlüsse der Transistoren M1-M4 mit den jeweiligen Eingängen 11-14 gemäß Fig. 1 sorgt bei der Ausgestaltung gemäß Fig. 3 jeweils die diagonal verlaufende erste Anschlussleitung 3.1, die sich entsprechend den zweiten bis vierten Anschlussleitungen 3.2-3.4 in diagonaler Richtung von Zelle 2 zu Zelle 2 durch das Feld 4 fortsetzt, ohne dass hierzu eine gesonderte Verbindung erforderlich wäre. In diesem Zusammenhang sei angemerkt, dass die erwähnten optionalen Anschlüsse 3.1a, 3.1b gemäß Fig. 2 lediglich zum vertikalen Verbinden der ersten Anschlussleitung mit darüber- oder darunter liegenden Metallebenen dienen.

Gemäß Fig. 3 ist Eingang I1 über eine Verbindung (Via) 3.6a ausgehend von der Anschlussleitung 3.14 mit der Anschlussleitung 3.6 verbunden. Von dort aus wird über eine weitere Verbindung (Via) 3.6b die Verbindung zu derjenigen ersten Anschlussleitung 3.1 hergestellt, welche die Gate-Anschlüsse dreier diagonal in dem Feld 4 hintereinander angeordneter Transistoren M1 bis hinunter zur untersten Zeile des Feldes 4 verbindet. Eine weitere Verbindung (Via) 3.6c kontaktiert die erste Anschlussleitung 3.1 des letzten verbliebenen Transistors M1 (links oben im Feld 4). Entsprechend sind die Transistoren M2 über die Anschlussleitungen 3.15 und 3.7 sowie Verbindungen (Vias) 3.7a-c mit dem Eingang I2 verbunden. Entsprechendes gilt auch für die Transistoren M3 in Bezug auf Eingang 13 (Anschlussleitungen 3.16 und 3.8 mit Verbindungen (Vias) 3.8a-c) und für die Transistoren M4 in Bezug auf Eingang I4 (Anschlussleitungen 3.17 und 3.5/3.9 mit Verbindungen (Vias) 3.5a/3.9a und 3.5b/3.9b). Dabei entsprechen die Verbindungen 3.Nb, 3.Nc (N = 5,...,9) den optionalen Verbindungen 3.1a,b in Fig. 2.

Wie der Fachmann erkennt, erfordert die Anordnung der Anschlussleitungen 3.1-3.4 in den Zellen 2 eine Permutation der Transistoren M1-M4 von Zeile zu Zeile bzw. Spalte zu Spalte in dem Feld 4. Es sei jedoch betont, dass alle Zellen 2 grundsätzlich, d.h. von ihrem Typ her, gleich aufgebaut sind, insbesondere was den Verlauf, die Anzahl und die Dimensionierung sämtlicher Anschlussleitungen anbelangt. Die unterschiedliche Funktionalität (Unterscheidung nach Transistoren M1-M4) der in den jeweiligen Zellen 2 enthaltenen Halbleiterelemente ergibt sich erst und allein durch das Vorsehen der angegebenen Verbindungen 3.Nm (N = 1,...,9, m = a,...,d).

Insbesondere laufen gemäß Fig. 3 die Anschlussnetze für die Ausgänge 01 und 02 (Anschlussleitungen 3.3, 3.4) in gleicher Weise über alle Zellen 2, sodass Gleichheit der parasitären Kapazitäten C1 (vgl. Fig. 1) gegeben ist, wie gefordert.

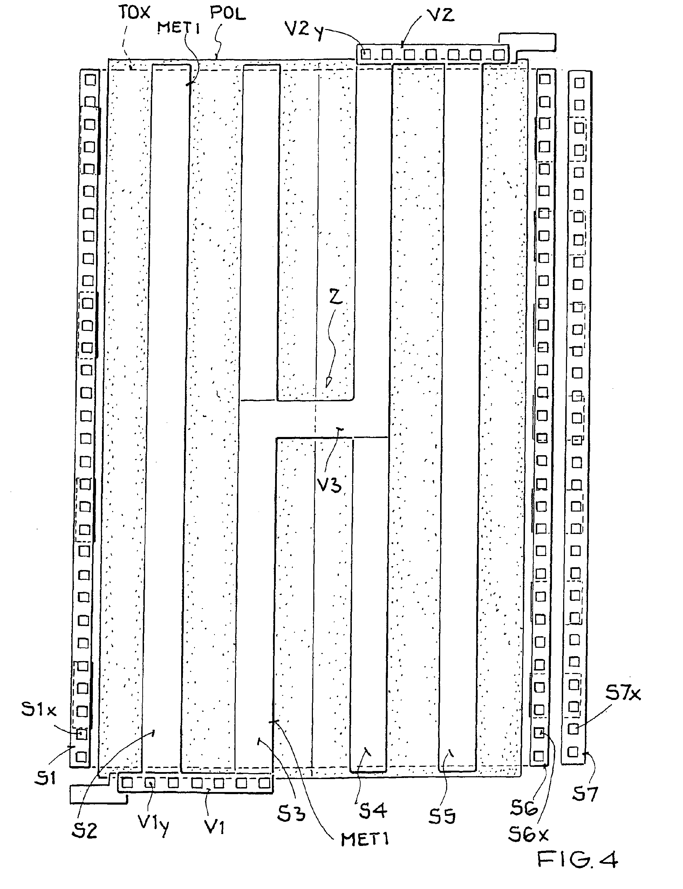

Fig. 4 zeigt einen ersten Horizontalschnitt eines Layouts für ein Halbleiterelement M in einem erfindungsgemäßen Halbleiterbauteil. Das vorliegende beschriebene Ausführungsbeispiel betrifft wiederum ein Layout für eine im Anschluss zu realisierende Schichtenabfolge zur Herstellung eines Transistors M (vgl. Fig. 2) für eine Verstärker-Eingangsstufe 1 (vgl. Fig. 1). Ein Layout eines Halbleiterbauteils bzw. eines Halbleiterbauelements ist ein Entwurf der für den Herstellungsprozess zu verwendenden Masken, wobei es vom Layout über die Maskentechnik zur Fertigung regelmäßig zu Invertierungen (positiv - negativ, dark - clear etc.) kommt.

Es sei an dieser Stelle weiterhin angemerkt, dass nachfolgend für die Ausbildung der Schichten verallgemeinernd der Ausdruck "angeordnet" verwendet wird, gleichgültig, ob es sich bei der jeweiligen Darstellung um konkret, d.h. physikalisch realisierte Schichten oder lediglich um geplante Strukturen innerhalb eines Layouts handelt.

Das in Fig. 4 mit TOX bezeichnete Rechteck (Maske) repräsentiert die aktiven Bereiche des Transistors (Drain, Kanal, Source). Um diesen Bereich wird ein dickes Oxid (TOX) aufgewachsen. Innerhalb des Bereiches wird ein dünnes Oxid, das spätere Gateoxid, erzeugt. Darüber wird Polysilizium abgeschieden und entsprechend der mit POL bezeichneten Maske strukturiert. Die unter dem Polysilizium herausragenden dünnen Oxidgebiete werden freigeätzt und unter Verwendung von Masken NPI und PPI (in den Figuren nicht gezeigt) implantiert. Letztere Gebiete werden allgemein als Aktivgebiete bezeichnet (P-Aktiv, N-Aktiv) und bilden Drain-, Source- und Bulkanschluss des Transistors (siehe unten). Auf dem Polysilizium sind erste Metallstrukturen als Leiterbahnen angeordnet. Die ersten Metallstrukturen sind im Wesentlichen als parallel zueinander verlaufende Streifen S1-S7 ausgebildet, wobei die Streifen S2-S5 länger und breiter ausgeführt sind als die Streifen S1, S6 und S7.

Die Streifen S1-S7 sind oberhalb der Gateoxid-Schicht angeordnet, die Streifen S2-S5 zusätzlich auch oberhalb der Polysilizium-Schicht. Die Streifen S2 und S3 sind an ihrem einen Ende mittels einer quer zur Erstreckung der Streifen S1-S7 verlaufenden Verbindungsstruktur V1 aus dem Metall der ersten Metallisierungsebene verbunden, im Folgenden auch als erste Metall MET1 bezeichnet. Gleiches gilt für die Streifen S4, S5, die an ihrem jeweiligen der Verbindungsstruktur V1 gegenüberliegendem Ende mittels einer Verbindungsstruktur V2 aus dem ersten Metall MET1 verbunden sind, wobei sich auch die Verbindungsstruktur V2 quer zur Erstreckung der Streifen S4, S5 erstreckt. Weiterhin sind die Streifen S3 und S4 in einem zentralen Bereich Z der beschriebenen Schichtenanordnung mittels einer Verbindungsstruktur V3 verbunden, die ebenfalls in dem ersten Metall MET1 ausgebildet ist und sich quer zu einer Erstreckung der Streifen S3, S4 erstreckt.

Im Bereich der Streifen S1, S6 und S7 sowie im Bereich der Verbindungsstrukturen V1 und V2 sind jeweils eine Mehrzahl von Kontaktlöchern S1x, S6x, S7x, V1y, V2y (x = 1, ..., 31; y = 1, ..., 7) einer Kontaktebene nebeneinander in Erstreckungsrichtung des jeweiligen Streifens bzw. der jeweiligen Verbindungsstruktur angeordnet. Die Kontaktlöcher S1x, S6x, S7x, V1y, V2y erstrecken sich von dem ersten Metall MET1 je nach Funktion hinunter bis auf ein Aktivgebiet (nicht gezeigt) oder bis auf das Polysilizium und sind mit einem leitenden Material, wie einem Silizid, Gold, Kupfer, Wolfram oder dergleichen, gefüllt.

Die Verbindungsstrukturen V1 und V2 bilden zusammen mit den Streifen S3 und S4 sowie der zentralen Verbindungsstruktur V3 einen diagonal durchlaufenden Gate-Anschluss (vgl. Anschlussleitung 3.1 in Fig. 2, 3). Entsprechend erfolgt mittels der Kontaktlöcher V1y, V2y eine Kontaktierung des Polysiliziums. Die Kontaktlöcher S1x, S6x und S7x in den Streifen S1, S6 und S7 sind durch das Oxid bis hinunter auf das Substrat bzw. dessen Aktivgebiete (nicht gezeigt) geführt, wobei der Streifen S1 als Drain-Anschluss, der Streifen S6 als Source-Anschluss und der Streifen S7 als Bulk-Anschluss fungiert.

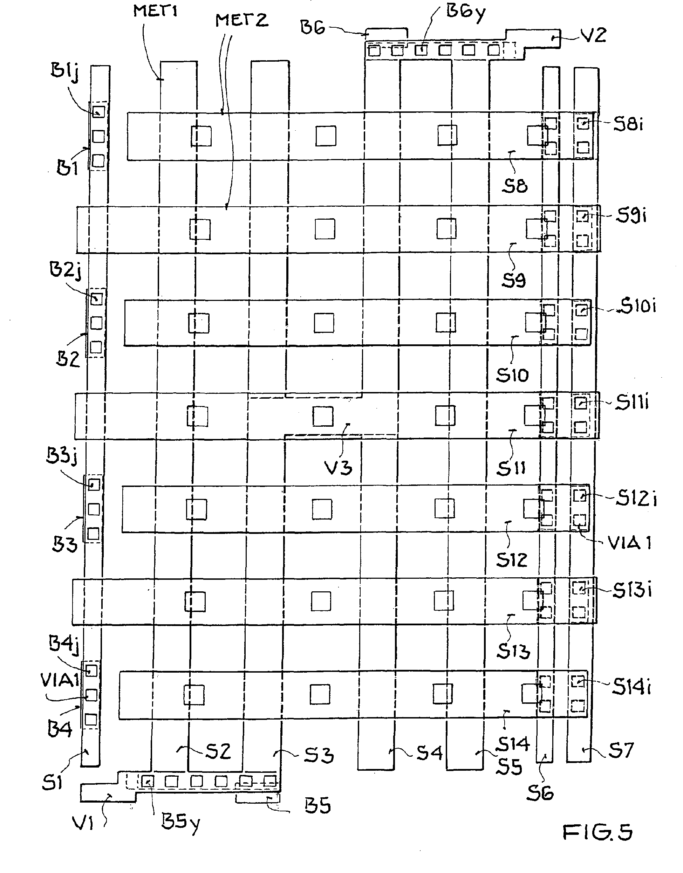

Fig. 5 zeigt einen zweiten Horizontalschnitt eines Layouts für eine Matching-Struktur. Aus Gründen der Übersichtlichkeit sind in Fig. 5 die Leiterbahnen des ersten Metalls MET1, die bereits unter Bezugnahme auf Fig. 4 erläutert wurden, nochmals dargestellt. Quer zu den Streifen S1-S7 gemäß Fig. 4 sind in der darüberliegenden Schicht gemäß Fig. 5 eine Mehrzahl von äquidistant angeordneten und sich jeweils parallel zueinander erstreckenden Streifen S8-S14 gleicher Breite aus einem zweiten Metall der zweiten Metallisierungsebene MET2 - nachfolgend auch als Metall MET2 bezeichnet - angeordnet. Dabei weisen die Streifen S8-S14 immer abwechselnd unterschiedliche Längserstreckungen auf:

So erstrecken sich die Streifen S8, S10, S12 und S14 beginnend oberhalb des Streifens S7 bis in den Bereich zwischen den Streifen S1 und S2, während die jeweils dazwischenliegenden Streifen S9, S11 und S13 sich ausgehend von dem Streifen S7 bis über den Streifen S1 hinaus erstrecken und dabei sogar den Streifen S7 noch geringfügig überragen. Der Streifen S11 verläuft oberhalb der Verbindungsstruktur V3. Im Bereich der Streifen S8-S14 sind oberhalb der Streifen S6 und S7 jeweils zwei Vias (VIA1) S8i-S14i (i = 1, 2, 3, 4) hinunter auf das erste Metall MET1 (vgl. Fig. 4) vorgesehen. Weiterhin sind in Verlängerung der kürzeren Streifen S8, S10, S12 und S14 aus dem zweiten Metall MET2 oberhalb des Streifens S1 Bereiche B1-B4 des zweiten Metalls MET2 angeordnet, die Vias (VIA1) B1j-B4j (j = 1, 2, 3) auf das erste Metall MET1 des Streifens S1 aufweisen. Des Weiteren sind im Bereich der Verbindungsstrukturen V1, V2 (vgl. Fig. 4) in Verlängerung des Streifens S3 bzw. S4 weitere Bereiche B5, B6 des zweiten Metalls MET2 vorgesehen.

Zumindest die vorstehend beschriebenen Streifen S8, S10, S12, S14 dienen über die Vias S8i, S10i, S12i, S14i als Source-/Bulk-Anschlüsse, während die Bereiche B1-B4, die über die Vias B1j-B4j mit der Drain-Schiene (Streifen S1) verbunden sind, als Drain-Anschlüsse fungieren. Die Bereiche B5 und B6 stellen dagegen entsprechende Gate-Anschlüsse dar. Die Bereiche B5 und B6 des zweiten Metalls MET2 sind über Vias B5y bzw. B6y mit der darunterliegenden Metallschicht MET1 im Bereich der ersten und zweiten Verbindungsstrukturen V1, V2 verbunden. Die Streifen S9 und S13 sind an ein Bezugspotential (Masse) angeschlossen.

Die Bereiche B5 und B6 des zweiten Metalls MET2 sind im Wesentlichen L-förmig ausgebildet, wobei ein Schenkel des L's, der sich in der Draufsicht in Verlängerung des Streifens S3 bzw. S4 des ersten Metalls MET1 erstreckt, deutlich kürzer als der jeweils andere Schenkel des L's ausgebildet ist.

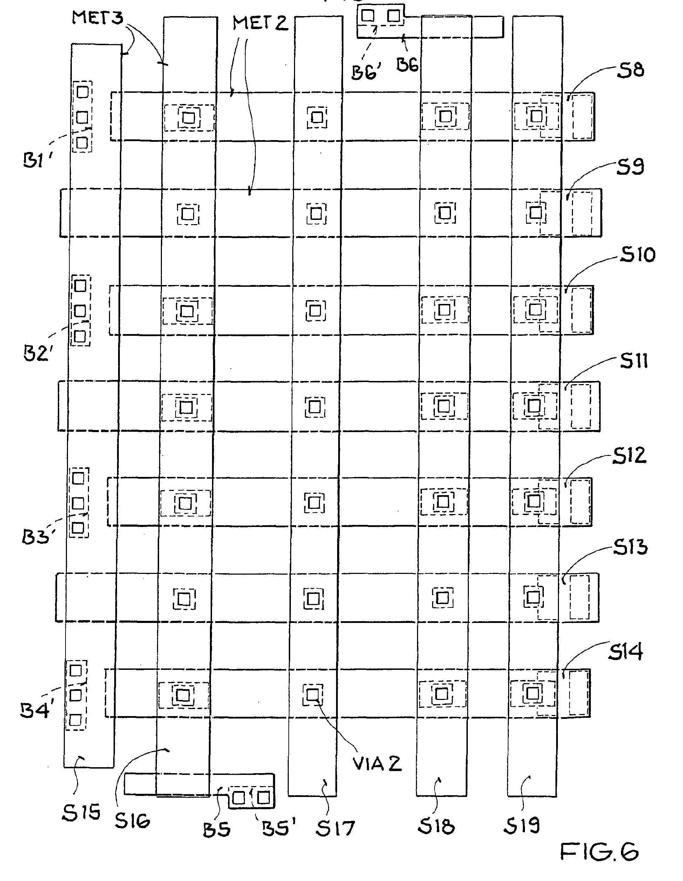

Fig. 6 zeigt einen dritten Horizontalschnitt eines Layouts für eine Matching-Struktur 1. Auf der gezeigten Ebene sind eine Anzahl von Streifen S15-S19 auf einem dritten Metall der dritten Metallisierungsebene - im Folgenden auch als Metall MET3 bezeichnet - angeordnet, deren Verlauf parallel zu dem der Streifen S1-S7 aus dem ersten Metall MET1 (vgl. Fig. 4, 5) ist. Die Streifen S15-19 sind geringfügig breiter als die Streifen S8-S14 aus dem zweiten Metall MET2 und deutlich breiter als die Streifen S1-S7 auf dem ersten Metall MET1 (vgl. Fig. 4) ausgebildet, insbesondere deutlich breiter als die Streifen S1-S6 und S7. Der Streifen S15 verläuft versetzt oberhalb des Streifens S1, der Streifen S16 überlappt teilweise mit dem Streifen S2, und der Streifen S17 verläuft mittig zwischen den Streifen S3 und S4. Der Streifen S18 überlappt teilweise mit dem Streifen S5, und der Streifen S19 verläuft versetzt oberhalb des Streifens S6. Der Streifen S15 ist kürzer ausgebildet als die Streifen S16-S19. An Kreuzungspunkten der Streifen S16-S19 mit den darunter liegenden Streifen S8-S14 aus dem zweiten Metall MET2 sind Via-Verbindungen VIA2 vorgesehen, die in Fig. 6 nur exemplarisch bezeichnet sind. Weiterhin sind Bereiche B5', B6' des dritten Metalls MET3 vorgesehen, die im Wesentlichen oberhalb der kurzen Schenkel der L-förmigen Bereiche B5, B6 des zweiten Metalls MET2 angeordnet sind. Auch in den Bereichen B5', B6' existieren Via-Verbindungen VIA2 vom dritten Metall MET3 auf das zweite Metall MET2. Weitere Via-Verbindungen VIA2 existieren im Bereich des Streifens S15 in Verlängerung jeweils der darunter liegenden Streifen S8, S10, S12 und S14 des zweiten Metalls MET2.

Der Streifen S15 fungiert auf diese Weise als Drain-Schiene, während die Streifen S16-S19 als Source-/Bulk-Anschluss und die Bereiche B5' und B6' als Gate-Anschluss fungieren.

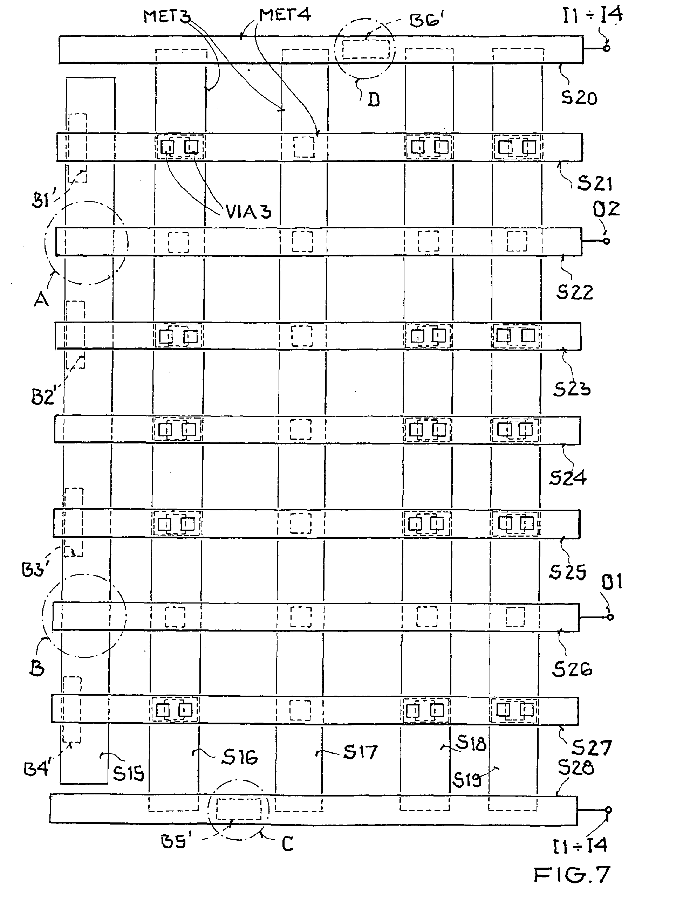

Fig. 7 zeigt einen vierten Horizontalschnitt eines Layouts für eine Matching-Struktur in einer Halbleiterschaltung als Halbleiterbauteil. Auf dieser Ebene ist durch regelmäßig beabstandete, quer zu den darunterliegenden Streifen S15-S19 des dritten Metalls MET3 verlaufende Streifen S20-S28 eines vierten Metalls einer vierten Metallisierungsebene MET4 - im Folgenden als viertes Metall MET4 bezeichnet - eine regelmäßige Metallstruktur geschaffen. Die Streifen S20-S28 des vierten Metalls MET4 erstrecken sich jeweils über den gesamten durch die Streifen S15-S19 des dritten Metalls MET3 eingenommenen Bereich. Die Streifen S21, S23, S24, S25 und S27 sind über Paare von Via-Verbindungen VIA3 jeweils mit den darunterliegenden Streifen S16, S18 und S19 verbunden. Die Streifen S20, S28 erstrecken sich oberhalb der Bereiche B6' bzw. B5' (vgl. Fig. 6) des dritten Metalls MET3; sie entsprechen den Anschlussleitungen 3.5-3.9 in Fig. 2, 3. Die Streifen S21-S27 verlaufen oberhalb der Streifen S8-S14 des zweiten Metalls MET2 (vgl. Fig. 5). Dabei sind die Streifen S21, S23, S25 und S27 über die Erstreckung der Streifen S8, S10, S12 und S14 hinaus bis oberhalb von Bereichen B1'-B4' des dritten Metalls MET3 verlängert, die oberhalb den Bereichen B1-B4 des zweiten Metalls angeordnet sind (vgl. Fig, 5).

Die Streifen S21, S23-S25 und S27 bilden den Source-/Bulk-Anschluss für das zu schaffende Halbleiterbauteil (Transistor). Dabei ist die anhand der Figuren 4 bis 7 beschriebene Struktur zunächst noch als eine Art Halbzeug anzusehen, dessen endgültige Funktion durch das Schaffen optionaler weiterer Anschlüsse im Bereich der Streifen S20, S22, S26 bzw. S28 bestimmt wird. Bezug nehmend auf die Darstellung in Fig. 1 bzw. Fig. 3 kann im Bereich der Streifen S22 im Bereich A über eine weitere Via-Verbindung VIA3 der Drain-Anschluss des zu schaffenden Transistors mit dem Ausgang 02 verbunden werden. Alternativ kann im Bereich des Streifens S26 bei B ein Drain-Anschluss über eine weitere Via-Verbindung VIA3 geschaffen werden, sodass der Drain-Anschluss des Transistors mit dem Ausgang 01 verbunden ist. Mittels optionaler Gate-Anschlüsse über weitere Via-Verbindungen VIA3 im Bereich C oder D kann der Transistor weiterhin mit seinem Gate-Anschluss mit einem der Eingänge I1-I4 verbunden werden. Die alternativen Drain-Anschlussleitungen S22, S26 liegen oberhalb den an Bezugspotential angeschlossenen MET2-Streifen S9 bzw. S13 (vgl. Fig. 5, 6), und sind somit gegen das darunter liegende Gate (vgl. Fig. 4) abgeschirmt. Aus diesem Grund sind die Streifen S9 und S13 breiter ausgeführt als die Streifen S22 und S26.

Mit anderen Worten: Die anhand der Figuren 4 bis 7 erläuterte Struktur kann nach Art der Zelle 2 in Fig. 2 dazu verwendet werden, ein Feld 4 von Halbleiterelementen gemäß Fig. 3 zu bilden, indem durch optionales Schaffen zusätzlicher (Via-)Verbindungen gemäß Fig. 7 (Bereiche A-D) gleiche Halbleiterelemente zu Halbleiterbauteilen zusammenschaltbar sind, die höchsten Matching-Anforderungen entsprechen. Dies wird durch die gleichmäßige Überdeckung der Fläche mit Metallstreifen aller Lagen erreicht, wodurch eine homogene Überdeckung der Fläche mit Streifen aller Metalllagen erreicht wird, die pro Schicht geforderte Überdeckungsgrade von beispielsweise 30-70% erreicht, ohne dass hierzu nachträglich aufwändige Metallauffüllungen vorgenommen werden müssen.

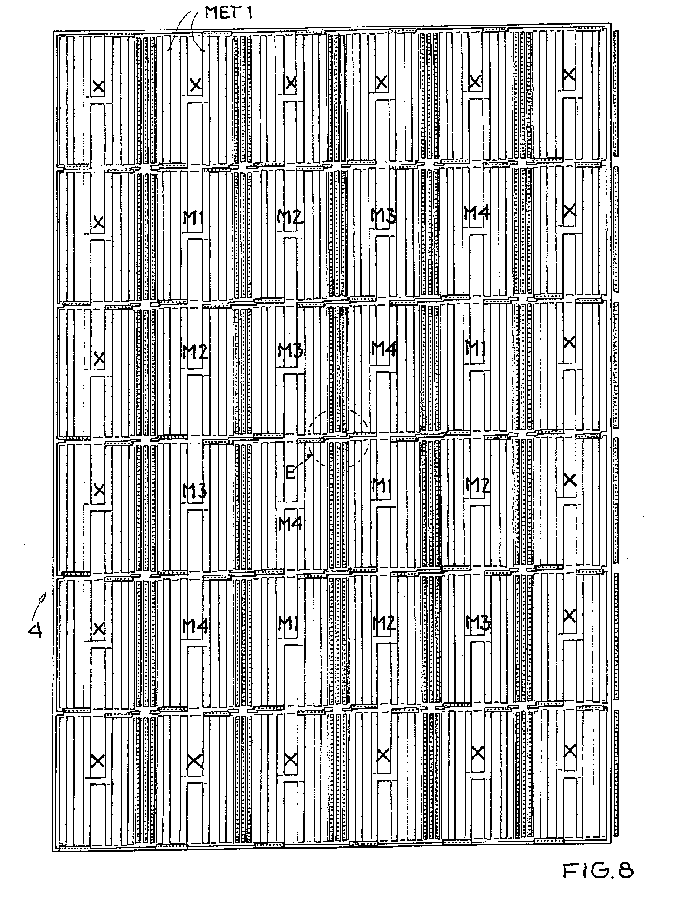

Figuren 8 bis 11 zeigen jeweils einen Horizontalschnitt durch ein Layout für eine Anordnung von Halbleiterelementen gemäß den Figuren 4 bis 7. Dargestellt ist die Anordnung von Strukturen gemäß Fig. 4 bis 7 bei Anordnung in einem Feld 4 gemäß Fig. 3. Die einzelnen Strukturen gemäß Fig. 4 bis 7 stellen - wie bereits erwähnt - einzelne Zellen 2 gemäß Fig. 3 dar, wobei die einzelnen Zellen entsprechend den durch sie bereitgestellten Halbleiterbauteilen (Transistoren) in Fig. 3 mit M1-M4 bezeichnet sind. Die mit M1-M4 bezeichneten Zellen sind von einer rahmenförmigen Anordnung von Dummy-Zellen - mit "X" gekennzeichnet - umgeben, die aus Symmetriegründen, insbesondere zum Herausführen der Leitungen (Verbindung mit Massepotential GND, Eingängen I1-I4 und Ausgängen 01-02) dienen. Die Dummy-Zellen dienen zur Schaffung einer topologisch identischen Umgebung für alle Elemente und besitzen abgesehen von den Vias den gleichen Aufbau wie diese.

Wie bei E exemplarisch dargestellt bzw. hervorgehoben ist, sind die Gate-Anschlüsse der Transistoren gleicher Art, d.h. M1 oder M2 oder M3 oder M4 durch das erste Metall MET1 (vgl. Fig. 4) diagonal durch das Feld 4 verbunden (vgl. Fig. 3; Anschlussleitung 3.1).

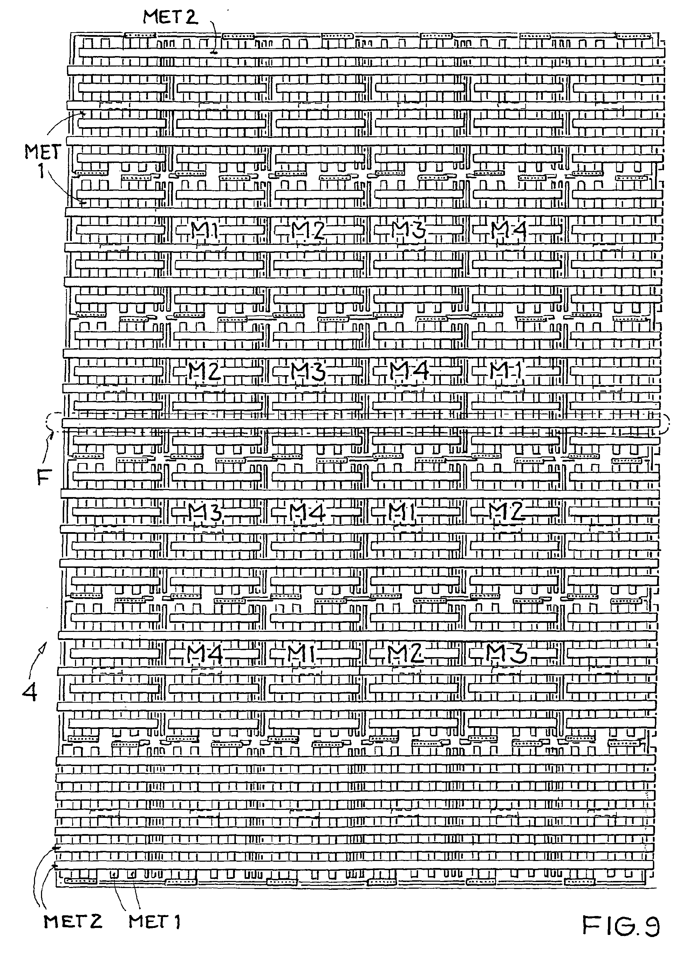

Fig. 9 zeigt bei F exemplarisch die Verbindung der Source- und Bulk-Anschlüsse einer Reihe über das zweite Metall MET2 (vgl. Anschlussleitungen 3.2 in Fig. 2, 3).

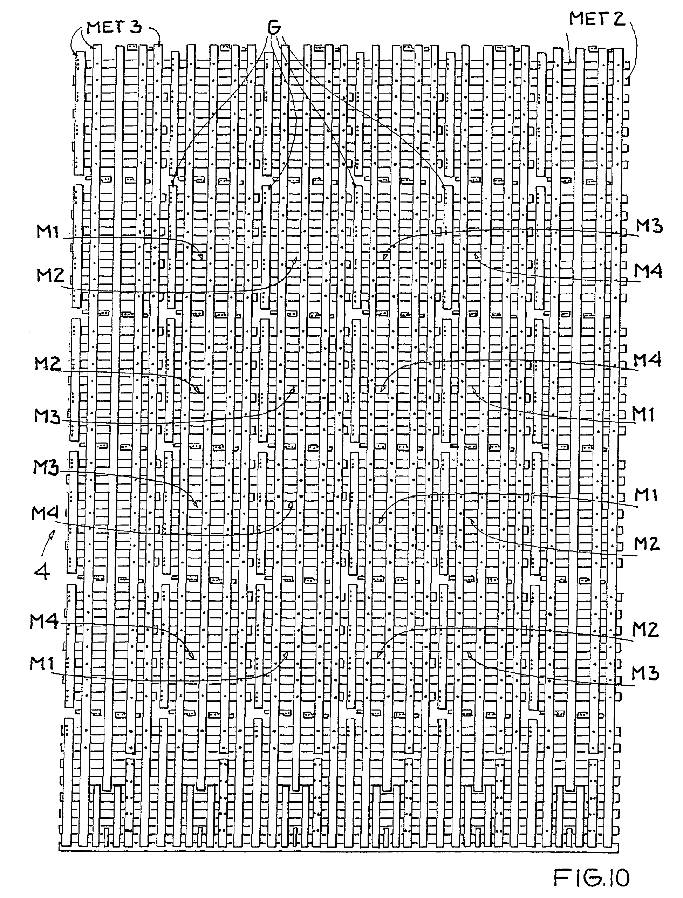

Fig. 10 verdeutlicht bei G exemplarisch die in dem dritten Metall MET3 ausgeführten Drain-Anschlüsse (vgl. Anschlussleitungen 3.3, 3.4 in Fig. 2, 3).

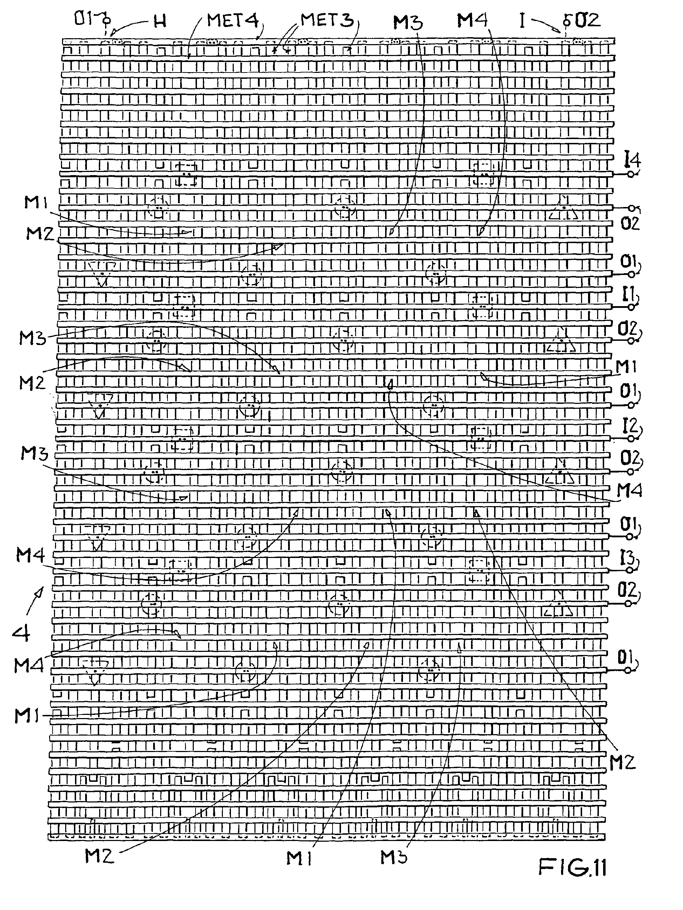

Fig. 11 zeigt an den mit Quadraten markierten Stellen den Anschluss der Gate-Leitungen über Via-Verbindungen VIA3 an die Eingänge I1-I4. Diese entsprechen den Verbindungen 3.5x-3.9x (x = a, b, c) in Fig. 3. An den mit einem Kreis markierten Stellen sind die Anschlüsse der Ausgänge (Drains) über Via-Verbindungen VIA3 realiert. Diese entsprechen den in Fig. 3 exemplarisch dargestellten Verbindungen 3.4c, 3.4d für den Ausgang 01 bzw. 3.3c, 3.3d für den Ausgang 02. Zusammenfassungen der Ausgangsleitungen (entsprechend Leitungen 3.10, 3.11 in Fig. 3) sind in Fig. 11 bei H (für Ausgang O1) bzw. I (für Ausgang 02) dargestellt. Verbindungen entsprechend den Verbindungen 3.3b, 3.4b in Fig. 3 (ebenfalls über Via-Verbindungen VIA3) sind in Fig. 11 mit auf der Spitze stehenden Dreiecken (für Ausgang 01) bzw. aufrecht stehenden Dreiecken (für Ausgang 02) gekennzeichnet.

Auf diese Weise schafft die vorliegende Erfindung ein Verfahren zum Entwerfen und zur anschließenden Herstellung von einzelnen Halbleiterelementen oder zusammengesetzten Halbleiterbauteilen, die in einem Feld aus insbesondere gleichen Halbleiterelementen gebildet werden. Das beschriebene Verfahren lässt sich also nicht nur in der Planungsphase zur Erstellung entsprechender Layouts für Halbleiterelemente oder -bauteile einsetzen, beispielsweise im Rahmen computergestützter bzw. softwarebasierter Layout-Verfahren, sondern dient - durch Erzeugen entsprechender Layout- oder Maskendaten - darüber hinaus auch als Herstellungsverfahren zur tatsächlichen Herstellung derartiger Halbleiterbauteile im Rahmen ansonsten bekannter Standardprozesse, wie oben detailliert beschrieben.

Die Zellenstruktur gemäß den Figuren 2 bzw. 4 bis 7 oder ein aus derartigen Zellen zusammengesetztes Feld gemäß Fig. 3 bzw. Fig. 8 bis 11 lässt sich auch als Halbzeug für die nachfolgende Herstellung von Halbleiterbauteilen verwenden und wirtschaftlich nutzen.

Das Layout- oder ein darauf aufbauendes Herstellungsverfahren gemäß dem Ausführungsbeispiel insbesondere der Fig. 2 garantiert topographische. Gleichheit aller Leiterbahngeometrien von Transistor zu Transistor in ein und derselben Metallisierungsebene für zumindest die untersten Metallisierungsebenen und ist somit geeignet, auch höchste Matching-Anforderungen zu erfüllen. In Synergie lassen sich auch Anforderungen bezüglich der Parasiten (parasitären Kapazitäten und/oder parasitärer Induktivitäten) aller Zuleitungen optimal erfüllen. Die von einem bestimmten Prozess geforderte Mindestdichte aller Leiterbahn (beispielsweise 30-70% der Oberfläche) kann leicht vorab eingestellt und in einfacher Weise eingehalten werden. Durch das Entfallen der Handverdrahtung gemäß dem Ausführungsbeispiel der Figuren 8 bis 10 wird zudem das Erstellen von Layouts wesentlich erleichtert, sodass die Designzeit und entsprechende Kosten reduziert werden. Die dabei erzeugten Layout-Zellen gemäß dem Ausführungsbeispiel der Figuren 4 bis 7 sind wieder verwertbar, d.h. sie können zu beliebig großen Feldern für die Erzeugung von Halbleiterschaltungen als Halbleiterbauteile angeordnet werden.

Wie der Fachmann erkannt, können für andere Halbleiterschaltungen als die hier exemplarisch dargestellte Verstärker-Eingangsstufe, z.B. für einen mit binärer Gewichtung arbeitenden Digital-Analog-Wandler (DAC), andere und/oder zusätzliche Via-Verbindungen, als in Fig. 11 gezeigt, zwischen den Metallisierungsebenen erforderlich sein. Darüber hinaus bedeutet die gewählte Bezeichnung "erstes" bis "viertes" Metall nicht notwendiger Weise, dass es sich hierbei um physikalischchemisch unterschiedliche Metalle handeln muss. Vielmehr sind wenigstens einige der Metallebenen vorzugsweise in einem gleichen Metall ausgebildet. Auch ist es möglich eine oberhalb der vierten Metallisierungsebene weitere Metallisierungsebenen vorzusehen, die manuell oder auch automatisch verdrahtet werden können.

## Patentansprüche

1. Halbleiterschaltung
- mit einer Matching-Struktur (1), die eine Anzahl von Transistoren (M1-M4) aufweist, deren Aufbau einander gleichen,
- mit Metallisierungsebenen (MET1-MET4) mit geometrisch ausgebildeten Leiterbahnen (S1-S28), die unmittelbar oberhalb der Transistoren (M1-M4) ausgebildet sind,
- mit Vias (VIA1, V1A2, VIA3) (in Viaebenen), die zwischen zwei der Metallisierungsebenen (MET1, MET2, MET3, MET4) ausgebildet sind,
- bei der innerhalb ein und derselben Metallisierungsebene (MET1, MET2, MET3, MET4) die Geometrie der Leiterbahnen (S1-S28) oberhalb jedes Transistors (M1-M4) gleich ausgebildet ist.

2. Halbleiterschaltung nach Anspruch 1,
- bei der die Transistoren (M1-M4) der Matching-Struktur zueinander benachbart angeordnet sind, und
- bei der innerhalb ein und derselben Metallisierungsebene (MET1, MET2, MET3, MET4) zumindest eine Leiterbahn (S1-S28) der Geometrie oberhalb eines Transistors (M1, M2, M3, M4) (der Transistoren) an zumindest eine Leiterbahn (S1-S28) eines benachbarten Transistors (M1, M2, M3, M4) (der Transistoren) zur Ausbildung einer leitenden Verbindung (3.1-3.4) grenzt.

3. Halbleiterschaltung nach einem der vorhergehenden Ansprüche, bei der zumindest innerhalb der untersten Viaebene die Position der Vias (VIA1, VIA2) bezüglich des Aufbaus jedes Transistors (M1-M4) gleich ist.

4. Halbleiterschaltung nach Anspruch 3, bei der in der dritten Viaebene oder in einer Viaebene oberhalb der dritten Viaebene die Position der Vias (VIA3, 3.4c, 3.4d) bezüglich des Aufbaus jedes Transistors (M1-M4) - zur Verschaltung der Transistoren (M1-M4) untereinander- unterschiedlich ist.

5. Halbleiterschaltung nach einem der vorhergehenden Ansprüche, bei der die Geometrie der Leiterbahnen (S1-S28) innerhalb zumindest einer Metallisierungsebene (MET1-MET4) eine Mehrzahl zueinander paralleler Streifen (S1-S28), insbesondere in einem äquidistanten Abstand aufweist.

6. Halbleiterschaltung nach einem der vorhergehenden Ansprüche,
- bei der die Matching-Struktur (1) Dummy-Transistoren (X) aufweist, die einen Aufbau aufweisen, der dem der Transistoren (M1-M4) gleicht,
- bei der die Dummy-Transistoren (X) am Rand der Matching-Struktur (1) angeordnet sind, und
- bei der innerhalb ein und derselben Metallisierungsebene (MET1-MET4) die Geometrie der Leiterbahnen (S1-S28) oberhalb jedes Transistors (M1-M4) und jedes Dummy-Transistors (X) gleich ausgebildet ist.

7. Halbleiterschaltung nach einem der vorhergehenden Ansprüche, bei der nur außerhalb der Matching-Struktur (1) zwischen Leiterbahnen der Metallisierungsebenen (MET1-MET4) automatisch angeordnete Füllstrukturen vorgesehen sind.

8. Halbleiterschaltung nach Anspruch 7, bei der zumindest innerhalb ein und derselben Metallisierungsebene (MET1, MET2, MET3, MET4) außerhalb der Matching-Struktur (1) ein erstes Überdeckungsverhältnis von Leiterbahnen und Füllstrukturen zu freibleibender Fläche und ein zweites Überdeckungsverhältnis der Geometrie der Leiterbahnen (S1-S28) zu freibleibender Fläche der Matching-Struktur (1) innerhalb ein und desselben Wertebereichs, insbesondere im Wertebereich zwischen 30% und 70% liegen.

9. Verfahren zur Erzeugung eines Layouts einer Halbleiterschaltung mit einer Matching-Struktur (1), die eine Anzahl von Transistoren (M1-M4) aufweist, deren Aufbau einander gleichen,
- bei dem Leiterbahnen (S1-S28) in Metallisierungsebenen (MET1-MET4) unmittelbar oberhalb der Transistoren (M1-M4) in einer Geometrie ausgebildet werden,
- bei dem Vias (V1A1-V1A4) in Viaebenen zwischen zwei Metallisierungsebenen (MET1, MET2, MET3, MET4) ausgebildet werden,
- bei der innerhalb ein und derselben Metallisierungsebene (MET1, MET2, MET3, MET4) die Geometrie der Leiterbahnen (S1-S28) oberhalb jedes Transistors (M1-M4) gleich ausgebildet wird.

10. Verfahren nach Anspruch 9, bei dem jeder Transistor (M1-M4) der Matching-Struktur (1) als Modul (2) mit unveränderlichen Geometrien der Leiterbahnen in den Metallisierungsebenen (MET1, MET2, MET3, MET4), insbesondere benachbart zu einem weiteren Transistor (M1, M2, M3, M4) der Matching-Struktur (1) positioniert wird.

11. Verfahren nach einem der Ansprüche 9 oder 10, bei dem nach einer Positionierung der Transistoren (M1-M4) der Matching-Struktur (1) zwischen Leiterbahnen der Metallisierungsebenen (MET1, MET2, MET3, MET4) Füllstrukturen automatisch angeordnet werden, wobei im Bereich der Matching-Struktur (1) die automatische Anordnung von Füllstrukturen deaktiviert wird.

12. Verfahren nach einem der Ansprüche 9 bis 11, bei dem nach der Positionierung der Transistoren (M1-M4) der Matching-Struktur (1) mit den Geometrien der Leiterbahnen der Metallisierungsebenen (MET1, MET2, MET3, MET4) Verbindungen (K5, K6, 3.4c, 3.4d) der Transistoren (M1-M4) der Matching-Struktur (1) durch die Positionierung von Vias (3.4c, 3.4d) insbesondere in der obersten Viaebene ausgebildet werden.

13. Verwendung eines Transistorlayouts einer Matching-Struktur (1) in einem Layout-Generierungsverfahren, bei der das Transistorlayout unveränderliche Geometrien von Leiterbahnen (S1-S28) in mehreren unmittelbar oberhalb eines Transistors (M1-M4) ausgebildeten Metallisierungsebenen (MET1, MET2, MET3, MET4) aufweist, wobei die Geometrien der Leiterbahnen (S1-S28) zum Aufbau des Transistors (M1-M4) positioniert sind.
